# EUROPEAN PATENT SPECIFICATION

(11) **EP 1 807 819 B1**
(45) Date of publication and mention of the grant of the patent: **23.12.2009**
(21) Application number: 05737792.1
(22) Date of filing: 10.05.2005
(51) Int. Cl.: G09F 27/00

(54) **DISPLAY FOR PUBLIC USE**
ANZEIGE FÜR ÖFFENTLICHE BENUTZUNG
AFFICHEUR A USAGE PUBLIQUE

(30) Priority: 03.11.2004 SI 200400298
(43) Date of publication of application: 18.07.2007
(73) Proprietor: Ogorevc, Andraz, 1291 Skofljica (SI)
(72) Inventor: Ogorevc, Andraz, 1291 Skofljica (SI)
(74) Representative: Primozic, Alenka
(86) International application number: PCT/SI2005/000012
(87) International publication number: WO 2006/049586

(56) References cited:
- FR-A- 2 756 653
- FR-A- 2 835 351
- US-A- 4 446 643
- US-A- 5 263 756
- US-A- 5 430 463
- PATENT ABSTRACTS OF JAPAN vol. 014, no. 051 (E-0881), 30 January 1990 (1990-01-30) & JP 01 277074 A (SONY CORP; others: 02), 7 November 1989 (1989-11-07)

## Description

The invention relates to a display for public use including a stand, an internal computer and an internal air conditioning system.
US 4,446,643 A (Fujita et al.) and US 5,263,756 A (Gaspar et al.) describe a display without a stand and in which air is conditioned in the entire space and all devices are located within same space.

Ad (i): FR 2 756 653 (G. Secerovski) discloses a large panel wide format television display for public use. Said device includes a television screen installed in a housing. A television receiver is connected to a computer system mounted in a foot of a structure. Also within said foot of said structure there may be an air conditioning system serving to keep the equipment at a constant temperature. A floor panel of said housing is covered by a grill for diffusing the conditioned air streaming from below, and a perforated plate is arranged over said grill as a carrier for the television receiver. The screen may be 350 cm high, and 300 cm wide.

As the computer resides in the foot next to the air conditioning system it is obvious that the conditioned atmosphere is only provided for the display With its dimensions, the foot in comparison to the display represents an aesthetic disproportion as well as a material expenditure. Besides, a mere combination of the grill for diffusing the conditioned air and the perforated carrier plate does not result in a homogenous conditioning, whose dryness is a substantial parameter of the interior space of the display.
US 5,430,463A (Fontalirant et A1) discloses a similar device, whereas the patents FR 2 835 351 A (Cotep) and PAJ vol. 014 No. 051 (E-0881)(1990-01-30) & JP 01 277074 S (Sony Corp; others 02) disclose devices with a ventilation airing system.

Hence, the invention proceeds from a problem of obviating the disadvantages of the prior art and, simultaneously, creating a display for public use with said display being of relatively large size measured by meters, and its service invariant as to weather conditions in their wide scope, particularly invariant also to temperature ranges below the freezing point and beyond 40°C, respectively.

With a display for public use including a stand, an internal computer and an internal air conditioning system, said problem is solved, according to the present invention, by that the computer is arranged inside a housing of the display, an evaporator of an air conditioning device acting as an air delivering member, with said device being arranged inside the hollow stand of the display, is connected from below to an opening in the floor panel of the housing of the display, while a compressor of the air conditioning device acting as a member for drawing in air is arranged on the floor panel of the stand. The compressor arranged within a stand resists to a temperature higher than ambient temperature, whereas the remaining devices, i.e. a computer that needs temperature conditions within narrower tolerances are arranged within the housing with the display. Also the computer thus resides in the atmosphere of conditioned air, and the dimensions of the stand are thus only subordinated to the compressor:

Hereinafter, the present invention is disclosed in more detail on the basis of a primary embodiment and four co-pending alternatives of an inventive display for public use shown in the annexed drawing. In the drawing,

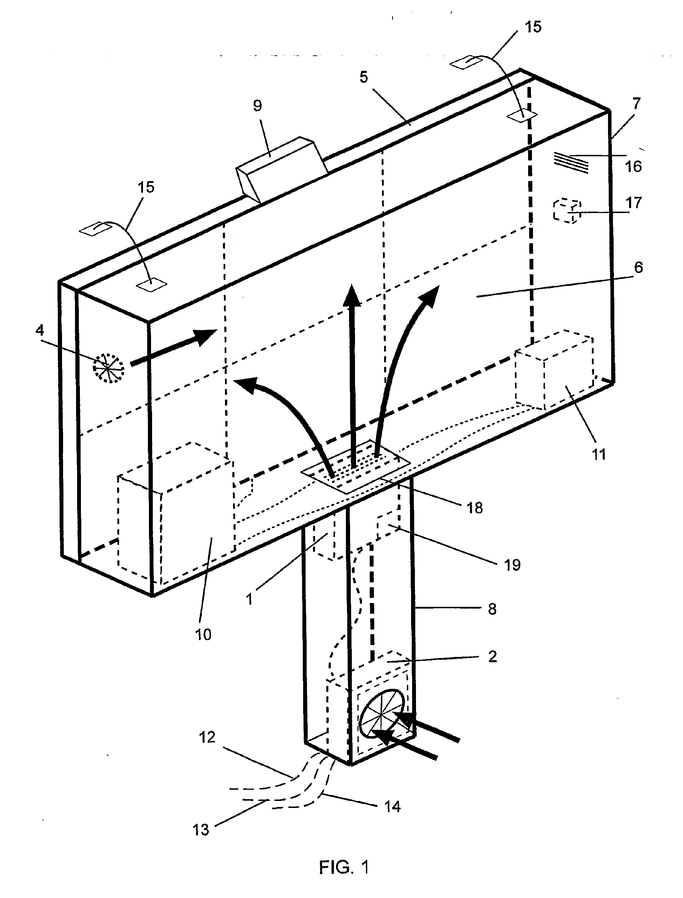

FIG. 1 is an embodiment of an inventive display for public use.

In the described embodiment, a selected reference number indicates a constructional member and intangibility, respectively, providing the same function.

In a narrower meaning of the word, display is limited to a housing 7, whose front wall is made of a glass panel 5. Behind the glass panel 5, at least one video apparatus 6 is arranged inside the housing 7 with said video apparatus per se being an independent construction. In the proposed five shown embodiments, a set of six video apparatuses 6 is foreseen in each of them.

In a free inside space of the housing 7 of the display behind the video apparatuses 6, there resides a functional equipment of the display or a part thereof.

In shown embodiment, an air conditioning device is composed of an evaporator 1, a compressor 2, a control unit 19 and interconnecting cables and pipelines, through which a working fluid flows. The control unit 19 is integrated in the evaporator 1 that in the air conditioning device is an air-delivering member. Air conditioning means air heating/cooling, elimination of static electricity as well as controlling of the dampness of air in the housing 7.

To the equipment of the housing 7 of the display there belong an inner equipment: a ventilator 4 for mixing air in the housing 7, a sensor 17 for detecting the temperature and dampness of air in the housing 7 as well as gills 16 for venting the housing 7; and an outer equipment: lamps 15 and a loudspeaker 9, provided the display for public use is an audio installation.

It the embodiment of FIG. 1, a first end part of a floor panel of the housing 7 supports a computer 10, a second one supports a feeder 11 for feeding the display with energy for the case of the external feeding being failed. There between resides, over a stand 8, an opening 18 in the floor panel of the housing 7 of the display.

It is to note that a hood can conveniently be installed between the evaporator 1 and the housing 7 of the display.

Outer conduits, such as an electric connection 12, an Internet connection 13 and a television cable 14 are connected to the installation.

## Claims

1. Display for public use including a hollow stand (8) a housing (7), a computer (10) an air condition device (1,2) **characterised in that** an internal computer (10) is arranged inside the housing (7), the air conditioning device (1, 2), the air conditioning device is arranged inside the hollow stand (8), an evaporator (1) of the air conditioning device (1, 2) is connected to an opening (18) in the floor panel of the housing (7), while a compressor (2) of the air conditioning device acting as a member for drawing in air is arranged on the floor panel of the stand (8).

2. Display according to claim 1, **characterized in that** a discharge hood is installed between an evaporator (1) of an air conditioning device and the housing (7) of the display.

## Patentansprüche

1. Anzeige für öffentliche Benutzung umfassend einen hohlen Fuß (8), ein Gehäuse (7), ein Computer (10), eine Klimaanlage (1, 2), **dadurch gekennzeichnet, dass** das Innencomputer (10) im Inneren des Gehäuses (7) angeordnet ist, dass die Klimaanlage (1, 2) im Inneren des hohlen Fußes (8) angeordnet ist, dass ein Verdampfer (1) der Klimaanlage (1, 2) mit einer Öffnung (18) in der Bodenplatte des Gehäuses (7) verbunden ist, indem der Kompressor (2) der Klimaanlage, der als ein Element zum Lufteinsaugen funktioniert, in der Bodenplatte des Fußes (8) angeordnet ist.

2. Anzeige nach Anspruch 1, **dadurch gekennzeichnet, dass** zwischen dem Verdampfer (1) der Klimaanlage und dem Gehäuse (7) der Anzeige eine Ablasshaube angeordnet ist.

## Revendications

1. Afficheur à usage publique comprenant un pied creux (8), une boîte (7), un ordinateur (10), un climatiseur (1, 2), charactérisé en ce que l'ordinateur interne (10) est disposé à l'intérieur de la boîte (7), le climatiseur (1, 2) est disposé a l'intérieur du pied creux (8), l'évaporateur (1) du climatiseur (1, 2) est joint avec un orifice (18) dans la plaque de fond de la boîte (7), alors que le compresseur (2) du climatiseur, qui fonctionne comme un membre pour l'aspiration de l'air, est disposé dans la plaque de fond du pied (8).

2. Afficheur selon la revendication 1, charactérisé en ce qu'un capot de sortie est disposé entre l'évaporateur (1) du climatiseur et la boîte (7) de l'afficheur.
